# FASCICULE DE BREVET EUROPEEN

(11) **EP 1 424 774 B1**
(45) Date de publication et mention de la délivrance du brevet: **31.08.2011**
(21) Numéro de dépôt: 03300232.0
(22) Date de dépôt: 26.11.2003
(51) Int. Cl.: H03K 3/84, G06F 7/58

(54) **Générateur de nombres aléatoires**
Zufallszahlengenerator
Random number generator

(30) Priorité: 27.11.2002 FR 0214906
(43) Date de publication de la demande: 02.06.2004
(73) Titulaire: STMicroelectronics S.A., 92120 Montrouge (FR)
(72) Inventeur: Bardouillet, Michel, 13790 Rousset (FR)
(74) Mandataire: de Beaumont, Michel

(56) Documents cités:
- EP-A- 0 365 930
- US-A- 4 855 690
- US-B1- 6 247 033
- PETRIE C S ET AL: "MODELING AND SIMULATION OF OSCILLATOR-BASED RANDOM NUMBER GENERATORS" 1996 IEEE INTERNATIONAL SYMPOSIUM ON CIRCUITS AND SYSTEMS (ISCAS). CIRCUITS AND SYSTEMS CONNECTING THE WORLD. ATLANTA, MAY 12 - 15, 1996, IEEE INTERNATIONAL SYMPOSIUM ON CIRCUITS AND SYSTEMS (ISCAS), NEW YORK, IEEE, US, vol. 4, 12 mai 1996 (1996-05-12), pages 324-327, XP000618584 ISBN: 0-7803-3074-9

## Description

La présente invention concerne un générateur de nombres aléatoires réalisé à partir d'oscillateurs à des fréquences différentes.

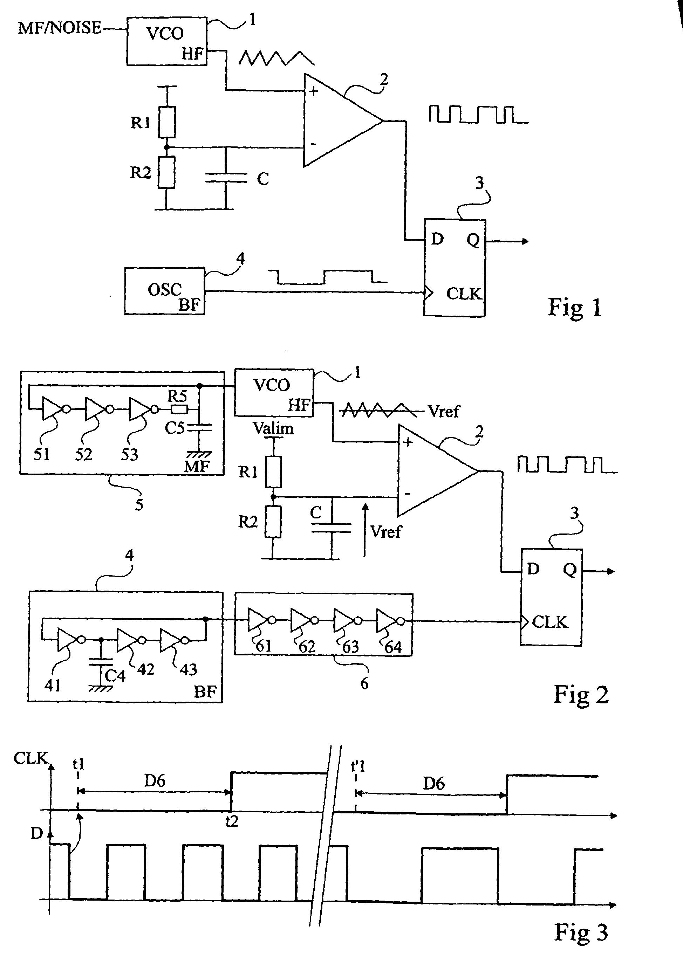

La figure 1 représente, de façon très schématique et sous forme de blocs, un exemple classique de générateur de nombres aléatoires du type auquel s'applique la présente invention. De tels générateurs sont divulgués dans les documents US-A-4 855 690 et EP-A- 0 365 930.

Un tel générateur est basé sur l'utilisation d'un premier oscillateur 1 commandé en tension (VCO) dans une plage prédéterminée de fréquences relativement hautes (HF). La commande de l'oscillateur 1 provient soit d'un oscillateur de fréquence (MF) inférieure (non représenté) soit d'un bruit électronique (NOISE) provenant généralement du même circuit intégré. La sortie de l'oscillateur 1 fournit un signal triangulaire de fréquence variable destiné à constituer, le cas échéant après une mise en forme par un comparateur 2, le signal d'entrée D d'une bascule 3 dont la sortie Q fournit un train numérique constituant un nombre aléatoire. Le rôle du comparateur 2 est simplement de mettre sous forme de créneaux le signal issu de l'oscillateur 1. Pour cela, une de ses entrées, par exemple non inverseuse, reçoit la sortie de l'oscillateur 1 tandis que son autre entrée (par exemple, inverseuse) reçoit une tension de référence fournie par un pont diviseur résistif R1, R2 au point milieu duquel est connecté un condensateur C de filtrage fournissant la tension de référence pour le comparateur 2.

Un deuxième oscillateur 4 (OSC), à une fréquence relativement basse (BF) par rapport à la fréquence de l'oscillateur 1 fournit un signal d'horloge à l'entrée CLK de la bascule 3. La fréquence BF de l'oscillateur 4 est prédéterminée.

A chaque front (par exemple, montant) du signal de sortie de l'oscillateur 4, la bascule 3 prend en compte l'état présent sur son entrée D. Comme cet état est à zéro ou à un selon le signal fourni par l'oscillateur 1, la sortie de la bascule 3 prend un état 0 ou 1 en sortie. Comme le signal de sortie de l'oscillateur 1 est d'une fréquence conditionnée par du bruit, la succession d'états 1 ou 0 en sortie de la bascule 3 constitue une suite d'états aléatoires.

Pour que le circuit de la figure 1 fonctionne ainsi, il est indispensable que les oscillateurs 1 et 4 ne soient pas synchronisés. En effet, dans le cas contraire, on assiste forcément à une suite de bits répétitive en sortie de la bascule 3. C'est notamment pour cette raison que l'entrée de commande en tension de l'oscillateur 1 est attaquée par un signal de fréquence intermédiaire (c'est-à-dire comprise entre la fréquence BF et la fréquence minimale de l'oscillateur 1) ou par du bruit. C'est aussi pour cela que la sortie de l'oscillateur 1 génère préférentiellement un signal triangulaire plutôt qu'une sinusoïde afin de garantir le caractère équiprobable des fréquences en sortie de l'oscillateur 1. La fréquence de l'oscillateur 1 varie dans la plage fixe prédéterminée selon la position d'une commande en tension sur la rampe de fréquence intermédiaire.

Un inconvénient du circuit de la figure 1 est qu'il subsiste toutefois un risque de synchronisation des oscillateurs. En effet, un bruit à la fréquence de l'oscillateur 1 se reporte sur l'alimentation et pollue ainsi l'oscillateur 4. Ce bruit synchronise les deux signaux. En effet, les déclenchements s'effectuent par rapport à des seuils. Or, la présence de bruit HF superposé à un signal à fréquence plus basse impose que les déclenchements par seuil interviendront prioritairement sur ce bruit. Cela revient bien à synchroniser les signaux.

Un exemple de générateur de nombres aléatoires tel qu'illustré par la figure 1 est décrit dans l'article «The intel Random number generator» de Benjamin Jun et Paul Kocher publié le 22 avril 1999 par Cryptography Research Inc.

La présente invention vise à proposer un nouveau générateur de nombres aléatoires qui pallie les inconvénients des générateurs à oscillateur connus.

L'invention vise plus particulièrement à résoudre les problèmes liés à une synchronisation éventuelle des signaux des oscillateurs haute fréquence et basse fréquence d'entrée de la bascule.

Pour atteindre ces objets et d'autres, la présente invention prévoit un générateur de nombres aléatoires par une bascule dont une entrée de donnée reçoit un premier signal à une première fréquence comprise dans une plage prédéterminée et dont la valeur instantanée est conditionnée par un signal perturbateur, et dont une entrée d'horloge reçoit un deuxième signal à une deuxième fréquence prédéterminée, inférieure à la première, ledit deuxième signal traversant un élément retardateur lui apportant un retard supérieur ou égal à la période maximale du premier signal.

Selon un mode de réalisation de la présente invention, ledit signal perturbateur est fourni par un troisième oscillateur à une fréquence intermédiaire entre lesdites première et deuxième fréquences.

Selon un mode de réalisation de la présente invention, le générateur comporte en outre un comparateur de mise en forme du signal fourni par le premier oscillateur avant arrivée sur l'entrée de données de la bascule.

Selon un mode de réalisation de la présente invention, le premier oscillateur est un oscillateur commandé en tension dont une entrée de commande reçoit ledit signal perturbateur.

Selon un mode de réalisation de la présente invention, la deuxième fréquence est choisie pour avoir un rapport d'au moins 100 avec la fréquence minimale du premier signal.

Selon un mode de réalisation de la présente invention, la fréquence du signal intermédiaire est choisie pour avoir un rapport compris entre 5 et 20 avec la fréquence minimale du premier signal.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment représente, schématiquement et sous forme de blocs, un exemple classique de générateur de nombres aléatoires du type auquel s'applique la présente invention ;
la figure 2 représente un mode de réalisation d'un générateur de nombres aléatoires selon l'invention ; et
la figure 3 illustre, par des chronogrammes, le fonctionnement du générateur de la figure 2.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les détails constitutifs de l'oscillateur commandé en tension, du comparateur et de la bascule n'ont pas été détaillés et ne font pas l'objet de l'invention.

Une caractéristique de la présente invention est de retarder, d'une durée prédéterminée, le signal fourni par un oscillateur à une fréquence relativement basse de commande d'une bascule fournissant la suite de nombres aléatoires. Selon l'invention, cette durée prédéterminée correspond de préférence à la période maximale d'une relative haute fréquence susceptible d'être fournie par un oscillateur commandé en tension, dont la sortie conditionne l'entrée de données de la bascule.

La figure 2 représente, de façon très schématique et sous forme de blocs, un mode de réalisation d'un générateur de nombres aléatoires selon l'invention.

Comme précédemment, ce générateur est basé sur une bascule 3 dont l'entrée de données D reçoit un signal à la fréquence d'un oscillateur commandé en tension 1 (VCO) ayant une plage de fréquences de fonctionnement prédéterminée et relativement élevée (HF). L'entrée d'horloge de la bascule est destinée à être commandée à une fréquence relativement basse (BF) par rapport à la fréquence de l'oscillateur 1. L'oscillateur 1 est commandé à une fréquence intermédiaire (MF) ou par du bruit. Dans l'exemple de la figure 2, on a illustré un oscillateur en anneau 5 à une fréquence intermédiaire commandant l'oscillateur 1.

De façon optionnelle et classique, le signal de sortie de l'oscillateur 1 peut être mis en forme par un comparateur 2 dont une première entrée (par exemple, non inverseuse) reçoit la sortie de l'oscillateur 1 tandis qu'une deuxième entrée (par exemple, inverseuse) reçoit une tension de référence Vref fournie, par exemple, par un pont diviseur résistif R1, R2 associé à un condensateur de lissage C. Le rôle du comparateur 2 est, par la tension de référence Vref, de fixer un niveau de prise en compte du signal triangulaire fourni par l'oscillateur 1 de façon à restituer un signal carré.

Dans l'exemple représenté, l'oscillateur 5 est constitué de trois inverseurs 51, 52, 53 en série. Un condensateur C5 conditionnant la fréquence d'oscillation relie la sortie de l'inverseur 53 à la masse, généralement avec interposition d'une résistance R5 pour obtenir un signal triangulaire. La sortie de l'inverseur 53 (ici, après traversée de la résistance R5) est rebouclée sur l'entrée de l'inverseur 51 et constitue le signal de commande en tension de l'oscillateur 1. Le fonctionnement d'un tel oscillateur en anneau est parfaitement classique et le nombre d'inverseurs est quelconque pourvu de rester impair. De même, l'oscillateur basse fréquence 4 est constitué d'inverseurs 41, 42 et 43 en série et d'un condensateur C4 reliant la sortie de l'inverseur 41 à la masse. Il présente donc la même structure en anneau que l'oscillateur 5, à la différence près qu'il ne comporte pas de résistance. La fréquence d'oscillation est conditionnée par la valeur du condensateur C4.

Selon la présente invention, l'entrée d'horloge CLK de la bascule 3 ne reçoit pas directement le signal issu de l'oscillateur 4 basse fréquence mais ce signal traverse au préalable un élément retardateur 6. Le retard apporté par l'élément 6 est choisi pour être au minimum égal à la période maximale du signal fourni par l'oscillateur haute fréquence 1. Idéalement, le retard sera égal à cette période maximale.

Dans l'exemple représenté, le retardateur 6 est constitué d'une association en série de plusieurs inverseurs 61, 62, 63, 64 dont le nombre est choisi en fonction de l'importance du retard souhaitée.

Le retardateur 6 permet que, même si accidentellement une période du signal fournie par l'oscillateur 4 se retrouve synchronisée avec le signal haute fréquence fourni par l'oscillateur 1, les périodes suivantes redeviendront désynchronisées en raison du retard apporté. On retrouve alors le caractère équiprobable des chiffres obtenus conditionnés uniquement par la source moyenne fréquence 5 ou de fréquence intermédiaire.

Or, le bruit éventuel introduit par l'oscillateur à fréquence intermédiaire 5 sur l'alimentation a forcément une fréquence inférieure ou égale à celle de l'oscillateur 1. En effet, pourvu que le bruit de l'oscillateur 5 ait une amplitude inférieure ou égale à celui de l'oscillateur 1, ce dernier masquera le bruit éventuel de l'oscillateur 5. Par conséquent, ce bruit à fréquence intermédiaire ne risque pas de provoquer une synchronisation. Par conséquent, l'oscillateur qui conditionne l'état de sortie de la bascule 3 est bien l'oscillateur de fréquence intermédiaire 5.

Ce fonctionnement est illustré par la figure 3 qui représente, sous forme de chronogrammes, un exemple d'allure du signal d'horloge CLK de la bascule 3 et du signal d'entrée D de cette bascule.

En partie gauche de la figure 3, on suppose que le signal de l'entrée D est à la fréquence maximale de l'oscillateur 1 (période minimale). En partie droite de cette figure, on suppose une fréquence issue de l'oscillateur 1 minimale (période maximale). Dans l'exemple, on considère le cas où la fréquence maximale correspond au double de la fréquence minimale.

En supposant une synchronisation accidentelle du signal de sortie de la bascule 4 (front pointillé t1 sur le signal CLK) avec l'entrée D de la bascule, le retard fixe D6 introduit par l'élément 6 (figure 2) conduit à ce que le front montant du signal d'horloge CLK intervient à un instant t2. On voit donc que l'état d'entrée D pris en compte s'effectue après une période du signal de fréquence maximale qui suit l'instant de synchronisation. Par conséquent, le risque lié à la synchronisation disparaît dans la mesure où elle s'effectue réellement. En partie droite de la figure 3, on suppose une synchronisation à un instant t'1. Là encore le retard D6 introduit fait que le front montant du signal CLK se produit au moins décalé d'une période par rapport à celle de la fréquence minimale.

Le délai D6 introduit est supérieur ou égal à la période maximale de l'oscillateur rapide 1. Il est, de préférence, égal à cette période maximale.

Un avantage de la présente invention est qu'elle évite les conséquences d'un risque de synchronisation des oscillateurs haute fréquence et basse fréquence du générateur de nombres aléatoires suite, par exemple, à une pollution du signal de fréquence intermédiaire par du bruit du signal haute fréquence.

Un autre avantage de l'invention est que sa mise en oeuvre est particulièrement simple. En effet, la modification à apporter à un générateur classique de nombres aléatoires à bascule et oscillateurs est d'ajouter un élément retardateur d'une durée prédéterminée en série avec l'oscillateur lent.

De préférence, la fréquence haute est au moins 100 fois plus grande que la fréquence basse, et la fréquence intermédiaire est entre 5 et 20 fois plus grande que la fréquence basse. A titre d'exemple particulier de réalisation, les fréquences respectives des oscillateurs peuvent être 1 kHz pour la basse fréquence (BF), 10 kHz pour la fréquence intermédiaire (MF) et une fréquence comprise entre 100 kHz et 200 kHz pour la haute fréquence (HF).

Bien entendu, la présente invention est susceptible de diverses variantes et modifications qui apparaîtront à l'homme de l'art. En particulier, la réalisation pratique de l'élément retardateur et des oscillateurs est à la portée de l'homme du métier à partir des indications fonctionnelles données ci-dessus et de l'application. On notera que d'autres formes d'oscillateurs que des oscillateurs en anneau à inverseurs pourront être utilisés. De plus, on notera que la précision du retard apporté par l'élément 6 n'est pas critique. Pour que le résultat d'équiprobabilité soit obtenu, il suffit que celui-ci soit calculé pour que, sur toute la plage de variation de l'oscillateur 1, on trouve moitié d'états 1, moitié d'états 0.

## Revendications

1. Générateur de nombres aléatoires par une bascule dont une entrée de donnée (D) reçoit un premier signal à une première fréquence (HF) comprise dans une plage prédéterminée et dont la valeur instantanée est conditionnée par une signal perturbateur, et dont une entrée d'horloge (CLK) reçoit un deuxième signal à une deuxième fréquence prédéterminée (BF), inférieure à la première, **caractérisé en ce que** ledit deuxième signal traverse un élément retardateur (6) lui apportant un retard supérieur ou égal à la période maximale du premier signal.

2. Générateur selon la revendication 1, **caractérisé en ce que** ledit signal perturbateur est fourni par un troisième oscillateur (5) à une fréquence intermédiaire (MF) entre lesdites première et deuxième fréquences.

3. Générateur selon la revendication 1 ou 2, **caractérisé en ce qu'**il comporte en outre un comparateur (2) de mise en forme du signal fourni par le premier oscillateur avant arrivée sur l'entrée de données (D) de la bascule (3).

4. Générateur selon l'une quelconque des revendi-cations 1 à 3, **caractérisé en ce que** le premier oscillateur (1) est un oscillateur commandé en tension dont une entrée de commande reçoit ledit signal perturbateur.

5. Générateur selon l'une quelconque des revendications 1 à 4, **caractérisé en ce que** la deuxième fréquence est choisie pour avoir un rapport d'au moins 100 avec la fréquence minimale du premier signal.

6. Générateur selon la revendication 5, **caractérisé en ce que** la fréquence du signal intermédiaire est choisie pour avoir un rapport compris entre 5 et 20 avec la fréquence minimale du premier signal.

## Claims

1. A generator of random numbers by a flip-flop, having a data input (D) receiving a first signal at a first frequency (HF) comprised in a predetermined range and the instantaneous value of which is conditioned by a disturbing signal, and having a clock input (CLK) receiving a second signal at a second predetermined frequency (BF), smaller than the first one, **characterized in that** said second signal passes through a delay element (6) giving it a delay greater than or equal to the maximum period of the first signal.

2. The generator of claim 1, **characterized in that** said disturbing signal is provided by a third oscillator (5) at an intermediary frequency (MF) between said first and second frequencies.

3. The generator of claim 1 or 2, **characterized in that** it further comprises a comparator (2) for setting-up the signal provided by the first oscillator before arrival on the data input (D) of the flip-flop (3).

4. The generator of any of claims 1 to 3, **characterized in that** the first oscillator (1) is a voltage-controlled oscillator having a control input receiving said disturbing signal.

5. The generator of any of claims 1 to 4, **characterized in that** the second frequency is selected to have a ratio of at least 100 with respect to the minimum frequency of the first signal.

6. The generator of claim 5, **characterized in that** the frequency of the intermediary signal is selected to have a ratio ranging between 5 and 20 with respect to the minimum frequency of the first signal.

## Patentansprüche

1. Vorrichtung zur Erzeugung von Zufallszahlen durch ein Flip-Flop mit einem Dateneingang (D), der ein erstes Signal mit einer ersten Frequenz (HF) empfängt, die in einem vorgegebenen Bereich liegt, wobei sein Momentanwert durch ein Störsignal beeinflusst ist, und dessen Takteingang (CLK) ein zweites Signal mit einer zweiten vorgegebenen Frequenz (BF), die niedriger ist als die Erste, empfängt, **dadurch gekennzeichnet, dass** das zweite Signal durch ein Verzögerungselement (6) hindurchgeht, welches diesem eine Verzögerung verleiht, die größer oder gleich der maximalen Periode des ersten Signals ist.

2. Erzeugungsvorrichtung von Anspruch 1, **dadurch gekennzeichnet, dass** das Störsignal von einem dritten Oszillator (5) bei einer Zwischenfrequenz (MF) zwischen der ersten und der zweiten Frequenz geliefert wird.

3. Erzeugungsvorrichtung von Anspruch 1 oder 2, **dadurch gekennzeichnet, dass** sie ferner ein Vergleicher (2) zum Formen des von dem ersten Oszillator gelieferten Signals, bevor dieses an den Dateneingang (D) des Flip-Flops (3) ankommt, aufweist.

4. Erzeugungsvorrichtung nach einem der Ansprüche 1 bis 3, **dadurch gekennzeichnet, dass** der erste Oszillator (1) ein spannungsgesteuerter Oszillator mit einem Steuereingang, welcher das Störsignal empfängt, ist.

5. Erzeugungsvorrichtung nach einem der Ansprüche 1 bis 4, **dadurch gekennzeichnet, dass** die zweite Frequenz so gewählt wird, dass sie ein Verhältnis von wenigstens 100 zu der minimalen Frequenz des ersten Signals hat.

6. Erzeugungsvorrichtung nach Anspruch 5, **dadurch gekennzeichnet, dass** die Frequenz des Zwischensignals so gewählt wird, dass sie ein Verhältnis zwischen 5 und 20 zu der minimalen Frequenz des ersten Signals hat.
